# EUROPEAN PATENT APPLICATION

(11) **EP 3 696 858 A1**
(43) Date of publication of application: **19.08.2020**
(21) Application number: 17928575.4
(22) Date of filing: 11.10.2017
(51) Int. Cl.: H01L 27/32

(54) **ORGANIC LIGHT-EMITTING DEVICE PACKAGING STRUCTURE AND METHOD FOR MANUFACTURE THEREOF, AND ORGANIC LIGHT-EMITTING APPARATUS**

(71) Applicant: Shenzhen Royole Technologies Co., Ltd., Shenzhen, Guangdong 518172 (CN)
(72) Inventor: LIAN, Wendong, Shenzhen, Guangdong 518115 (CN); CHEN, Yiming, Shenzhen, Guangdong 518115 (CN)
(74) Representative: Mewburn Ellis LLP
(86) International application number: PCT/CN2017/105745
(87) International publication number: WO 2019/071477

(57) **Abstract**

The present disclosure discloses a packaging structure of an organic light emitting device, a manufacturing method thereof, and an organic light emitting device. The packaging structure of the organic light emitting device includes a first inorganic layer disposed on a base plate and covering the organic light emitting device; a blocking part disposed on a periphery of the first inorganic layer; an organic layer and a second inorganic layer sequencely disposed on the first inorganic layer; the blocking part defines an enclosing part inside the blocking part on the first inorganic layer; the organic layer is disposed within the enclosing part. The packaging structure of the organic light emitting device of the present disclosure, in the packaging structure, the blocking part is disposed on the periphery of the first organic layer and is not covered by it, which prevents hydrophobicity of the blocking part from being changed and ensures that the blocking part effectively prevents overflow of the organic layer, and also effectively shortens a distance between the blocking part and an effective light emitting area of the organic light emitting device.

## Description

### TECHNICAL FIELD

The present disclosure relates to fields of light-emitting display technology, and in particular, to a packaging structure of an organic light emitting device, a manufacturing method thereof, and an organic light emitting device.

### BACKGROUND

The cathodes and organic light-emitting materials in OLED (Organic Light-Emitting Diode) devices fail because they easily react with water and oxygen in the air. Therefore, packaging materials are required to encapsulate OLED devices, and flexible OLEDs also necessarily require flexible packaging, namely TFE.

The structure currently used by TFE is inorganic layer, organic layer, and inorganic layer overlapped alternatively. The method for forming the organic layer is IJP, that is, an inkjet printer (Ink Jet Printer) is used for inkjet to form the organic layer. Because ink (organic material) has good fluidity, a bank similar to a baffle plate needs to be formed at both ends of a panel to prevent ink overflow. Generally, the formation of the bank is generally formed in the TFT process, but the bank is formed in the previous process. Since the first process in the TFE process is CVD (inorganic layer), the bank will be covered by this layer CVD, so the original hydrophobicity of the bank will be changed, and the effective overflow of ink cannot be effectively prevented. At the same time, a larger bank distance is required to effectively prevent ink overflow.

### SUMMARY

The technical problem to be solved by the present disclosure is to provide a packaging structure of an organic light emitting device which effectively prevents overflow of the organic layer and effectively shortens a distance between the blocking part and an effective light emitting area, and a manufacturing method of the packaging structure, and an organic light emitting device having the packaging structure.

The technical solution adopted by the present disclosure to solve its technical problem is to provide a packaging structure of an organic light emitting device, which includes a first inorganic layer disposed on a base plate and covering the organic light emitting device, a blocking part disposed on a periphery of the first inorganic layer, and an organic layer and a second inorganic layer which are sequentially disposed on the first inorganic layer;

The blocking part defines an enclosing part inside the blocking part on the first inorganic layer, and the organic layer is disposed within the enclosing part.

The present disclosure also provides a method for manufacturing a packaging structure of an organic light emitting device, which includes following steps:
S1. a first inorganic layer is formed on a base plate, and the first inorganic layer covers an organic light emitting device which is located on the base plate;
S2. a blocking part is formed on a periphery of the first inorganic layer, so that the blocking part defines an enclosing part inside the blocking part on the first inorganic layer;
S3. an organic layer is formed on the first inorganic layer, and the organic layer is disposed within the enclosing part;
S4. a second inorganic layer is formed on the organic layer.

The present disclosure also provides another method for manufacturing a packaging structure of an organic light emitting device, including following steps:
S1. in a TFT process, a blocking part is formed on a base plate; the blocking part is located on a periphery of the organic light emitting device which is located on the base plate;
S2. a mask is used to block the blocking part, and a first inorganic layer is formed on the base plate; the first inorganic layer covers the organic light emitting device, and the blocking part is located on a periphery of the first inorganic layer;
S3. an organic layer is formed on the first inorganic layer; the organic layer is disposed within an enclosing part formed between the blocking part and the first inorganic layer;
S4. a second inorganic layer is formed on the organic layer.

The present disclosure also provides an organic light emitting device, which includes a base plate, an organic light emitting device, and an aforementioned packaging structure;

The organic light emitting device is disposed on the base plate, and the packaging structure is disposed on the base plate and covers the organic light emitting device.

Beneficial effects of the present disclosure: In the packaging structure, the blocking part (Bank) is disposed on a periphery of the first organic layer and is not covered by it, which prevents the hydrophobicity of the blocking part from being changed, and ensures that the blocking part effectively prevents overflow of the organic layer, and also effectively shortens a distance between the blocking part and an effective emission area of the organic light emitting device.

### BRIEF DESCRIPTION OF THE ACCOMPANYING DRAWINGS

The present disclosure will be further described below with reference to the accompanying drawings and embodiments. In the drawings:

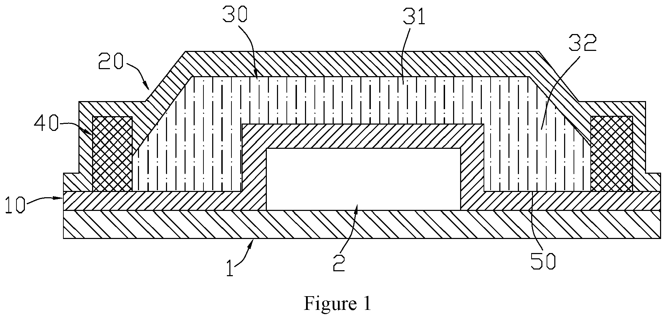

FIG. 1 is a schematic structural diagram of a packaging structure of an organic light emitting device according to one embodiment of the present disclosure.

### DETAILED DESCRIPTION OF ILLUSTRATED EMBODIMENTS

In order to have a clearer understanding of the technical features, objects, and effects of the present disclosure, specific embodiments of the present disclosure will now be described in detail with reference to the accompanying drawings.

As shown in FIG. 1, a packaging structure of an organic light emitting device according to one embodiment of the present disclosure includes a first inorganic layer 10 disposed on a base plate 1 and covering the organic light emitting device 2, a blocking part 40 disposed on a periphery of the first inorganic layer 10, and an organic layer 30 and a second inorganic layer 20 sequentially disposed on the first inorganic layer 10. The blocking part 40 defines an enclosing part 50 inside the blocking part 40 on the first inorganic layer 10. The enclosing part 50 is also located on a top side of the organic light emitting device 2, and the organic layer 30 is disposed within the enclosing part 50.

The organic light emitting device 2 may be an OLED device. The base plate 1 may be a glass base plate. The first inorganic layer 10, the organic layer 30, and the second inorganic layer 20 are sequentially stacked on the organic light emitting device 2 to protect an organic light emitting layer of the organic light emitting device 2 from water and oxygen. It can be understood that the packaging structure of the embodiment of the present disclosure can also be applied to other light emitting devices, such as a TFT device.

The first inorganic layer 10 is a first layer structure covering the organic light emitting device 2, which can be formed on the base plate 1 by a chemical vapor deposition method (DVD) or an atomic layer deposition method (ALD). As shown in FIG. 1, a middle portion of the first inorganic layer 10 covers an upper surface and side surfaces of the organic light emitting device 2, and a marginal part extends along the side surfaces of the organic light emitting device 2 to the base plate 1.

The blocking part 40 is located on a periphery of the first inorganic layer 10 on the base plate 1, and may be located on the periphery of the first inorganic layer 10 or on an outer side of the periphery of the first inorganic layer 10. A height of the blocking part 40 is greater than that of the first inorganic layer 10. The higher blocking part 40 can effectively prevent overflow of organic materials with strong fluidity when the inkjet printer performs inkjet printing to form the organic layer 30, so that the organic layer 30 can be completely disposed within the enclosing part50.

The blocking part 40 may be formed on the first inorganic layer 10 by using a mask combined with chemical vapor deposition or atomic layer deposition, or formed on the first inorganic layer 10 by using chemical vapor deposition combined with dry etching.

The blocking part 40 is made of hydrophobic insulating materials, so that it does not mix with the organic layer 30, etc., so that the organic layer 30 forms a certain shape on its inner side. Alternatively, the blocking part 40 can be made of silicon oxide (SiOx) or silicon nitride (SiNx).

Because the blocking part 40 is disposed on the periphery of the first inorganic layer 10 and is not covered by the first inorganic layer 10, the hydrophobicity of the blocking part 40 is not weakened, and the forming materials of the organic layer 30 are effectively prevented from overflowing during the manufacturing process of the organic layer 30. In addition, the blocking part 40 does not need to be set at a greater distance from an effective light emitting area of the organic light emitting device 2, which effectively shortens the distance between the blocking part 40 and the effective light emitting area, thereby facilitating the reduction in the overall volume of the organic light emitting device.

The organic layer 30 may be formed on the first inorganic layer 10 by an inkjet printing method (IJP), so that the organic layer 30 is an organic film layer formed of an organic material such as ink (Ink). Due to the blocking part 40 disposed on the periphery of the first inorganic layer 10, when the organic layer 30 is prepared, the ink is blocked by the blocking part 40 and does not flow to the outside of the blocking part 40.

In this embodiment, the organic layer 30 includes a flat section 31 corresponding to a top side of the organic light emitting device 2 and a slope section 32 coupled to an outer periphery of the flat section 31 and corresponding to a peripheral side of the organic light emitting device 2. One side of the slope section 32 away from the flat section 31 abuts against one side of the blocking part 40. A side height of slope section 32 is lower than or flush with a side height of blocking part 40.

The specific materials and preparation methods of the organic layer 30 can be realized through the existing technology.

The second inorganic layer 20 is disposed on the organic layer 30 and covers the blocking part 40. Corresponding to the structural composition of the organic layer 30, the second inorganic layer 20 covers the flat section 31 and the slope section 32 of the organic layer 30, and extends to an outer periphery of the blocking part 40, covering the blocking part 40. A marginal part of the second inorganic layer 20 may further extend to couple with the first inorganic layer 10.

Similarly to the first inorganic layer 10, the second inorganic layer 20 can be formed on the organic layer 30 by a chemical vapor deposition method (DVD) or an atomic layer deposition method (ALD). The second inorganic layer 20 and the first inorganic layer 10 can be made of same materials, and the specific materials and preparation methods can be realized by the existing technology.

Referring to FIG. 1, a method for manufacturing a packaging structure of an organic light emitting device according to one embodiment of the present disclosure, may include the following steps:
S1. a first inorganic layer 10 is formed on the base plate 1, and the first inorganic layer 10 covers the organic light emitting device 2 which is located on the base plate 1.
   The first inorganic layer 10 may be formed on the base plate 1 by a chemical vapor deposition method or an atomic layer deposition method.
S2. a blocking part 40 is formed on a periphery of the first inorganic layer 10, so that the blocking part 40 defines an enclosing part 50 inside the blocking part 40 on the first inorganic layer 10.
   The blocking part 40 may be formed on the first inorganic layer 10 by using a mask combined with chemical vapor deposition or atomic layer deposition, or formed on the first inorganic layer 10 by using chemical vapor deposition combined with dry etching.
S3. an organic layer 30 is formed on the first inorganic layer 10, and the organic layer 30 is disposed within the enclosing part 50.
   The organic layer 30 is formed on the first inorganic layer 10 by an inkjet printing method. Due to the limitation of the enclosing part 50, the organic layer 30 will not overflow to outside of the blocking part 40 during a formation process.

S4. a second inorganic layer 20 is formed on the organic layer 30.

Similarly, the first inorganic layer 10 and the second inorganic layer 20 can also be formed on the organic layer 20 by a chemical vapor deposition method or an atomic layer deposition method. In addition, the second inorganic layer 20 extends beyond the blocking part 40 and covers the blocking part 40.

Referring to FIG. 1, a method for manufacturing a packaging structure of an organic light emitting device according to another embodiment of the present disclosure may include the following steps:
S1. in a TFT process, a blocking part 40 is formed on the base plate 1; the blocking part 40 is located on a periphery of the organic light emitting device 2 which is located on the base plate 1.
S2. a mask is used to block the blocking part 40, and a first inorganic layer 10 is formed on the base plate 1.
   The first inorganic layer 10 covers the organic light emitting device 2, and the blocking part 40 is located on the periphery of the first inorganic layer 10, so that the blocking part 40 defines an enclosing part 50 inside the blocking part 40 on the first inorganic layer 10.
   The first inorganic layer 10 may be formed on the base plate 1 by a chemical vapor deposition method or an atomic layer deposition method.
S3. an organic layer 30 is formed on the first inorganic layer 10.
   The organic layer 30 is disposed within the enclosing part 50 formed between the blocking part 40 and the first inorganic layer 10.
   The organic layer 30 is formed on the first inorganic layer 10 by an inkjet printing method. Due to the limitation of the enclosing part 50, the organic layer 30 will not overflow to the outside of the blocking part 40 during a formation process.
S4. a second inorganic layer 20 is formed on the organic layer 30.

Similarly, the first inorganic layer 10 and the second inorganic layer 20 can also be formed on the organic layer 20 by a chemical vapor deposition method or an atomic layer deposition method. In addition, the second inorganic layer 20 extends beyond the blocking part 40 and covers the blocking part 40.

Referring to FIG. 1, the organic light emitting device of the present disclosure includes a base plate 1, an organic light emitting device 2, and the aforementioned packaging structure. The organic light emitting device 2 is disposed on the base plate 1, and the packaging structure is disposed on the base plate 1 and covers the organic light emitting device 2.

The base plate 1 may be a glass base plate; the organic light emitting device 2 may be an OLED device. In the packaging structure, the first inorganic layer 10, the organic layer 30, and the second inorganic layer 20 are sequentially stacked on the organic light emitting device 2 to protect an organic light emitting layer of the organic light emitting device 2 from water and oxygen.

In the packaging structure, because the blocking part 40 is disposed on the periphery of the first inorganic layer 10 and is not covered by the first inorganic layer 10, the hydrophobicity of the blocking part 40 is not weakened, and the formation material of the organic layer 30 are effectively prevented from overflowing during a formation process of the organic layer 30. In addition, the blocking part 40 does not need to be set at a greater distance from the effective light emitting area of the organic light emitting device 2, which effectively shortens the distance between the blocking part 40 and the effective light emitting area, thereby facilitating the reduction in the overall volume of the organic light emitting device.

The above description is only one embodiment of the present disclosure, and thus does not limit the patent scope of the present disclosure. Any equivalent structure or equivalent process transformation made by using the description and drawings of the present disclosure, or directly or indirectly applied to other related technologies same apply to the fields of patent protection of the present disclosure.

## Claims

1. A packaging structure for an organic light emitting device, comprising:
a first inorganic layer (10) disposed on a base plate (1) and covering the organic light emitting device (2);
a blocking part (40) disposed on a peripheral of the first inorganic layer (10);
an organic layer (30) and a second inorganic layer (20) sequentially disposed on the first inorganic layer (10);
the blocking part (40) defines an enclosing part (50) inside the blocking part (40) on the first inorganic layer (10); the organic layer (30) is disposed within the enclosing part (50).

2. The packaging structure of claim 1, wherein the second inorganic layer (20) is located on the organic layer (30) and covers the blocking part (40).

3. The packaging structure of claim 1, wherein the organic layer (30) comprises a flat section (31) corresponding to a top side of the organic light emitting device (2), and a slope section (31) coupled to an outer periphery of the flat portion (31) and corresponding to a peripheral side of the organic light emitting device (2); one side of the slope section (32) away from the flat section (31) abuts against one side of the blocking part (40).

4. The packaging structure of claim 3, wherein the second inorganic layer (20) covers the flat section (31) and slope section (32), and extends to an outer periphery of the blocking part (40), and covers the blocking part (40).

5. The packaging structure of claim 1, wherein the blocking part (40) is made of hydrophobic insulating materials.

6. The packaging structure of claim 5, wherein the blocking part (40) is made of silicon nitride or silicon oxide.

7. A method for manufacturing a packaging structure of an organic light emitting device, comprising following steps:
S1. a first inorganic layer (10) is formed on the base plate (1), and the first inorganic layer (10) covers the organic light emitting device (2) which is located on the base plate (1);
S2. a blocking part (40) is formed on a periphery of the first inorganic layer (10), so that the blocking part (40) defines an enclosing part (50) inside the blocking part (40);
S3. an organic layer (30) is formed on the first inorganic layer (10), and the organic layer (30) is disposed within the enclosing part (50);
S4. a second inorganic layer (20) is formed on the organic layer (30).

8. The manufacturing method of claim 7, wherein in step S1, the first inorganic layer (10) is formed on the base plate (1) by a chemical vapor deposition method or an atomic layer deposition method;
In step S3, the organic layer (30) is formed on the first inorganic layer (10) by an inkjet printing method;
In step S4, the second inorganic layer (20) is formed on the organic layer (30) by a chemical vapor deposition method or an atomic layer deposition method.

9. The manufacturing method of claim 7, wherein in step S2, the blocking part (40) is formed on the first inorganic layer (10) by using a mask combined with a chemical vapor deposition method or an atomic layer deposition method, or by using a chemical vapor deposition method combined with dry etching.

10. A method for manufacturing a packaging structure of an organic light emitting device, comprising following steps:
S1. in a TFT process, a blocking part (40) is formed on the base plate (1); the blocking part (40) is located on a periphery of the organic light emitting device (2) which is located on the base plate (1);
S2. a mask is used to block the blocking part (40), and a first inorganic layer (10) is formed on the base plate (1); the first inorganic layer (10) covers the organic light emitting device (2), and the blocking part (40) is located on a periphery of the first inorganic layer (10);
S3. an organic layer (30) is formed on the first inorganic layer (10); the organic layer (30) is disposed within an enclosing part (50) formed between the blocking part (40) and the first inorganic layer (10);
S4. a second inorganic layer (20) is formed on the organic layer (30).

11. The manufacturing method of claim 10, wherein in step S2, the first inorganic layer (10) is formed on the base plate (1) by a chemical vapor deposition method or an atomic layer deposition method;
In step S3, the organic layer (30) is formed on the first inorganic layer (10) by an inkjet printing method;
In step S4, the second inorganic layer (20) is formed on the organic layer (30) by a chemical vapor deposition method or an atomic layer deposition method.

12. An organic light emitting device, comprising a base plate (1), an organic light emitting device (2), and a packaging structure;
the packaging structure is a packaging structure according to any one of claims 1-6; or, the packaging structure is a packaging structure made by a manufacturing method according to any one of claims 7-9 or any one of claims 10-11;
the organic light emitting device (2) is disposed on the base plate (1), and the packaging structure is disposed on the base plate (1) and covers the organic light emitting device (2).
